# EUROPEAN PATENT SPECIFICATION

(11) **EP 1 831 922 B1**
(45) Date of publication and mention of the grant of the patent: **26.08.2009**
(21) Application number: 04806549.4
(22) Date of filing: 28.12.2004
(51) Int. Cl.: H01L 21/762

(54) **METHOD FOR OBTAINING A THIN LAYER HAVING A LOW DENSITY OF HOLES**
VERFAHREN ZUM ERHALTEN EINER DÜNNEN SCHICHT MIT EINER GERINGEN DICHTE VON LÖCHERN
PROCEDE SERVANT A OBTENIR UNE COUCHE MINCE POSSEDANT UNE DENSITE FAIBLE DE TROUS

(43) Date of publication of application: 12.09.2007
(73) Proprietor: S.O.I.Tec Silicon on Insulator Technologies, 38190 Bernin (FR)
(72) Inventor: BEN MOHAMED, Nadia, F-38140 Renage (FR); NEYRET, Eric, F-38360 Sassenage (FR); DELPRAT, Daniel, F-38920 Crolles (FR)
(74) Representative: Collin, Jérôme
(86) International application number: PCT/IB2004/004390
(87) International publication number: WO 2006/070220

(56) References cited:
- FR-A- 2 797 713
- US-A1- 2004 115 905
- US-A1- 2004 161 948
- US-A1- 2005 026 391
- US-B1- 6 403 450
- AUBERTON-HERVE A J ET AL: "SMART-CUT: THE BASIC FABRICATION PROCESS FOR UNIBOND SOI WAFERS" IEICE TRANSACTIONS ON ELECTRONICS, INSTITUTE OF ELECTRONICS INFORMATION AND COMM. ENG. TOKYO, JP, vol. E80-C, no. 3, March 1997 (1997-03), pages 358-363, XP000751689 ISSN: 0916-8524
- ASPAR B ET AL: "Smart-cut process: An original way to obtain tin films by ion implantation" ION IMPLANTATION TECHNOLOGY, 2000. CONFERENCE ON SEP. 17-22, 2000, PISCATAWAY, NJ, USA,IEEE, 17 September 2000 (2000-09-17), pages 255-260, XP010543059 ISBN: 0-7803-6462-7

## Description

The present invention relates to the production of a final structure comprising a thin layer of semiconductor material on a substrate, said production comprising the steps of:
- creating an embrittlement zone in the thickness of a donor substrate,
- placing the donor substrate into close contact with a support substrate,
- detaching the donor substrate at the level of the embrittlement zone to transfer a part of the donor substrate onto the support substrate.

The invention more precisely allows improving the properties of the thin layer, in particular by avoiding the presence of holes within the thin layer.

SMARTCUT^{™} type processes, for which more ample details can be found in the documents' Silicon-On-Insulator Technology: Materials to VLSI, 2nd Edition% by Jean-Pierre Colinge from Kluwer Academic Publishers, pp. 50 and 51 Smart-Cut®: The Basis Fabrication process for Unibond® Soi wafers, A.J. Auberton-Hervé T.Moisand et al., IEICE Transactions on Electronics, 27.11.08, vol. E80-C, pp. 358-363, March 1997, are an example of production of the type mentioned hereinabove and correspond to a preferred embodiment of the invention

SMARTCUT^{™} type processes advantageously produce structures comprising a thin layer of semiconductor material, such as SeOl (Semiconductor On Insulator) structures and the like.

The embrittlement zone can be created by implantation of species within the thickness of the donor substrate. Implantation of species is understood to mean any technique (such as bombardment, diffusion and the like) suitable for introducing atomic or ionic species onto the material of the implanted donor substrate, with a maximum concentration of the implanted species situated at a preset depth from the substrate relative to the surface of said implanted substrate.

It is mentioned here that when a SeOl structure is to be produced, a layer of oxide is intercalated in between the support substrate and the thin layer. For this purpose, the donor substrate may comprise on its top a superficial oxide layer which is to be placed, after the implantation step, into close contact with the support substrate so as to form the buried oxide layer of the final SeOl structure.

The implantation step can be performed either by implanting a single species (such as hydrogen) or by co-implanting at least two different species (such as the co-implantation of both hydrogen and helium).

Following the detachment step, the thin layer formed onto the support substrate presents a damaged zone extending on a certain depth.

In particular, holes may be observed on the surface of the thin layer. Some holes, which will be called "shallow holes" hereinbelow, are blind holes which extend part of the way into the thickness of the thin layer. Taking the case of a SOI structure as an example, these shallow holes extend In the thickness of the superficial thin silicon layer but do not extend down to the buried oxide layer.

On the other hand, some holes may be fairly deep, and may even extend all through the thickness of the thin layer. These holes will be called "killing holes" hereinbelow. Taking the case of a SOI structure as an example, these killing holes extend all through the superficial thin silicon layer, down to the underneath buried oxide layer.

Furthermore, one understands that this killing holes problem is all the more significant as the thickness of the thin layer is low (for instance less than 800 angstroms).

The resulting structures from SMARTCUT^{™} type processes are used for applications in the fields of microelectronics, optics and/or optronics. The specifications of the thin layer quality of the structures used in these fields are thus generally very strict.

The presence of holes is a parameter which to a certain extent conditions the quality of the components which will be created on the final structure. Holes are thus to be as much as possible avoided.

Furthermore killing holes are killer defects; indeed a component built on a killing hole will not function.

Shallow holes do not have such a disastrous effect on operation of the components built upon these structures. However, they form defects which it is desirable to avoid.

There is thus a need for a method for producing a high quality structure comprising a thin layer of semiconductor material on a substrate which makes it possible to minimize the density of holes within the thin layer, and notably the density of those of the holes which are killer defects, namely the killing holes.

As mentioned here above, this need is all the more significant as the desired thickness of the thin layer is low, that is typically less than 800 angstroms.

In order to fill the above mentioned need, the invention proposes, according to a first aspect, a method as set forth in claim 1.

Under a second aspect, the invention also relates to the use of the method of claim 1 for producing a final structure comprising a Hü- layer of semiconductor material transferred from a donar-substrate outer a support substrate.

Preferred but non restrictive forms of the use according to the second aspect of the invention are set forth in dependent claims 3-18.

Other characteristics, purposes and advantages of the invention will appear to the reading of the following detailed description, with respect to the annexed drawing, given as non restrictive example, in which:
- figure 1 schematically represents the hole density as a function of depth within a thin layer;
- figure 2 illustrates the effect of a RTA operation on a SOI structure;
- figure 3 represents the hole density within a SOI layer before and after a RTA operation;
- figure 4 illustrates the effect of a POL operation effect on a SOI structure;
- figure 5 represents the hole density within a SOI layer before and after a POL operation.
- figure 6 illustrate the effect of a SOx operation on a SOI structure;
- figure 7 represents the hole density within a SOI layer before and after a SOx operation;
- figure 8 represents the effect of sequences RTA/SOx and SOx/RTA on a SOI structure;
- figure 9 gives an example of the amelioration brought by a method according to a possible embodiment the invention;
- figure 10 illustrates the amelioration brought by the invention in term of final killing holes density;
- figure 11 is a flow chart illustrating a method according to a possible embodiment of the invention.

The present invention can help in improving the quality of a structure obtained by currying out a transfer process of the SMARTCUT^{™} type.

The structure can, in general, be any type of structure comprising a thin layer of semiconductor material on a surface exposed to the external environment.

In a non restrictive way, the thin layer of semiconductor material can be silicon Si, silicon carbide SiC, germanium Ge, silicon-germanium SiGe, gallium arsenide GaAs, etc.

The substrate support can be made of silicon Si, quartz, etc.

As already mentioned, a layer of oxide can also be intercalated in between the support substrate and the thin layer, the structure therefore formed being a SeOI (Semiconductor On Insulator) structure.

The description hereafter deals with SOI (Silicon On Insulator) structures manufacturing, but the man skilled in the art will understand that the invention is in no way limited to this particular example.

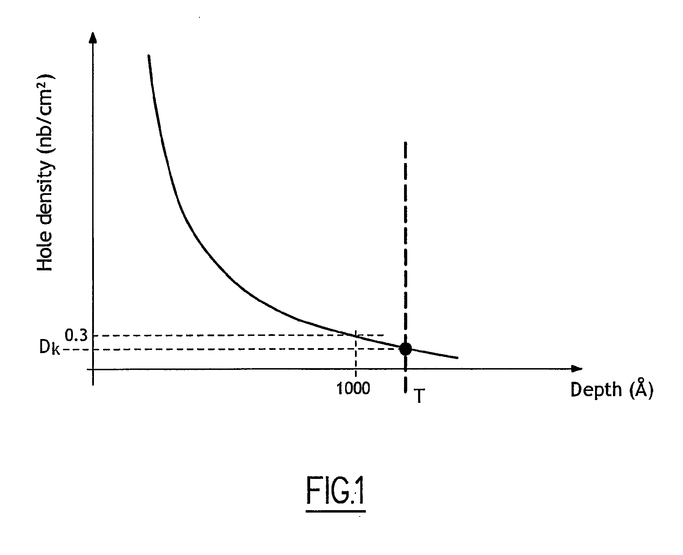

Figure 1 represents the hole density as a function of depth within a SOI transferred layer. The hole density is inversely proportional to the depth, and decreases quasi exponentially. Typically the deepest holes are between 1000 and 1400 angstroms deep, but their density is then relatively weak (typically the density of the holes deeper than 1000 angstroms is below 0,3 holes per cm²).

It has to be noted that the hole density is similar whether the implantation step is carried out by implanting a single species or by co-implanting at least two different species.

A killing hole is a hole which depth is equal to the thickness of the thin layer. Hence, as it is illustrated on figure 1, the killing hole density Dk is directly related to the thin layer thickness T.

This killing hole density is thus all the more significant as the thickness of the thin layer is low.

Hence, a thin SOI layer.presents a high killing holes density, whereas a thick SOI layer presents a low killing holes density. As illustrated by figure 1, a SOI layer which thickness T is greater than 1000 angstroms typically presents a killing holes density per cm² Dk less than 0,3.

Several finishing steps of the structure obtained after detachment have already been proposed which generally consist in a sequence of different operations and which aim at forming a thin layer suitable for a use in the field of microelectronics, optics and/or optronics.

These finishing steps generally make use of operations such as polishing (likewise referred to as POL hereinbelow), thermal annealing in a neutral or reducing atmosphere (likewise referred to as TA hereinbelow; such as a rapid thermal annealing RTA), sacrificial oxidation (likewise referred to as SOx hereinbelow), chemical etching, etc.

Rapid thermal annealing RTA is generally understood to mean rapid annealing (that is, performed over a period of several seconds or several tens of seconds), at a high temperature (for example of the order of 900°C to 1300°C), in a controlled atmosphere (such as a mixture of hydrogen and argon, or an atmosphere of pure argon, or even an atmosphere of pure hydrogen).

SOx is a sacrificial oxidation divided into an oxidation step and a deoxidation step, a heat treatment step (typically 2 hours long at 1100°C) being possibly inserted between the oxidation and deoxidation steps.

Chemical-mechanical polishing (CMP) is an example of a POL operation.

The following sequences of operations have for instance been proposed as finishing step of the structure obtained after detachment:
- SOx-POL-SOx (refer for instance to publication FR 2 797 174);
- SOx-RTA-POL-SOx (refer for instance to publication FR 2 797 713);
- RTA-SOx-RTA-SOx (refer for instance to the Applicant's French patent application filed on July, 27 2003 under n°03 09304).

As concern holes, the applicant has observed that the above mentioned operations can be separated into two families.

A first family concerns those operations which allow reducing the depth of the shallow holes, that is those holes which depth is lower than the thickness of the thin layer being formed (or stated differently those holes which do not extend down to the underneath buried oxide layer in the case of a SOI structure).

A second family concerns those operations which do not have any curing impact on holes

RTA and POL operations are instances of the first family, whereas SOx and chemical etching operations are instances of the second family.

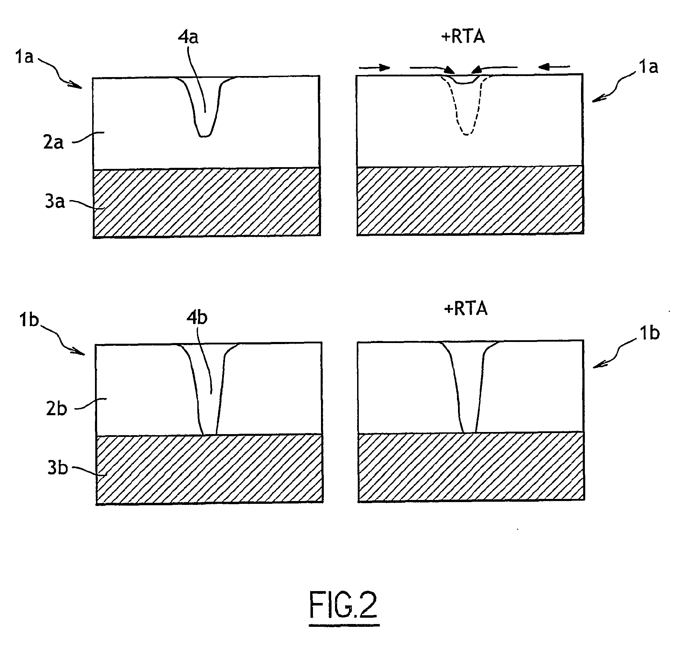

Figure 2 illustrates the effect of a RTA operation on SOI structures 1a, 1b composed respectively of a silicon layer 2a, 2b on top of a buried oxide layer 3a, 3b (the support substrates not being represented).

Silicon layer 2a of SOI structure 1a presents a shallow hole 4a which depth is lower than the thickness of the silicon layer 2a and thus does not extend down to the surface of the buried oxide layer 3a.

On the contrary, silicon layer 2b of SOI structure 1b presents a killing hole 4b which extends all through the thickness of the silicon layer 2b, down to the surface of the buried oxide layer 3b.

The RTA operation has a smoothing effect which helps strongly decreasing (by a factor 2 to 3 at least) the depth of the shallow holes (such as shallow hole 4a). Indeed these holes can be stopped, in particular thanks to diffusion and recrystallization, as it is schematically represented on the right hand side of figure 2 in respect of structure 1a.

However a RTA operation has no effect on the killing holes (such as hole 4b) which extend, prior to the RTA, through all the thin layer (in this case down to the surface of the buried oxide layer 3a). As it is schematically represented on the right hand side of figure 2 in respect of structure 1b, killing holes are not cured by a RTA operation.

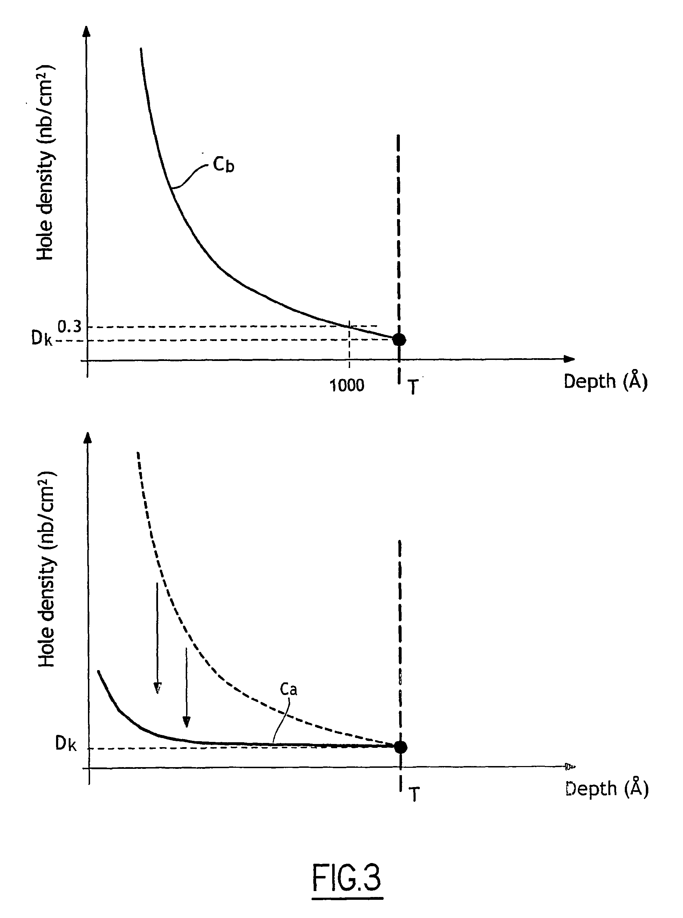

Figure 3 represents the hole density within a SOI layer before (top graph) and after (lower graph) a RTA operation. Before the RTA operation, the SOI layer of thickness T presents more or less deep shallow holes, in a density, illustrated by curve Cb, which depends upon the depth of these holes. The SOI layer also presents killing holes in a density Dk.

As mentioned here above, the RTA operation has no effect on killing holes. The killing holes density thus remains unchanged equal to Dk.

However, the RTA operation helps to cure the shallow holes, by decreasing their depth and even by stopping them. As a result of the RTA operation, the SOI layer presents shallow holes in a strongly decreased density, as illustrated by curve Ca.

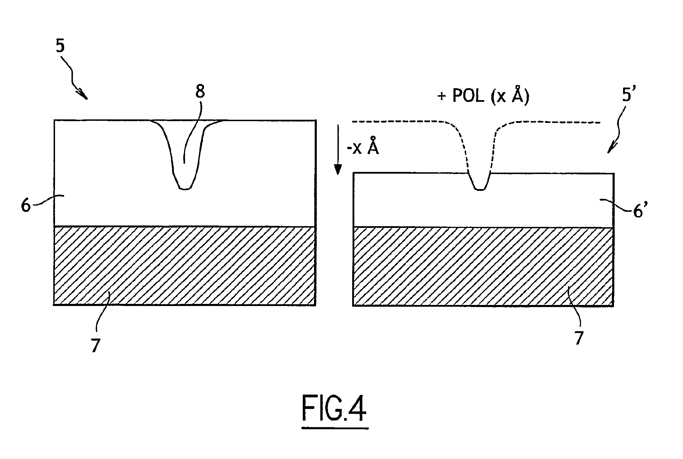

Figure 4 illustrates the effect of a POL operation on a SOI structure 5 composed of a silicon layer 6 on top of a buried oxide layer 7. The silicon layer 6 presents prior to the POL operation a shallow hole 8. As it is apparent on this figure, by removing x angstroms of the silicon layer 6, thus obtaining a thinned silicon layer 6', the depth of the shallow hole 8 is decreased.

Furthermore, the thickness of the silicon layer 6 being removed by the POL operation can be adjusted (being more important than the shallow hole depth) in order for said shallow hole to be removed by the POL operation.

However one understands that if the silicon layer presents a killing hole which extends down to the buried oxide layer, after polishing said silicon layer will still present this killing hole.

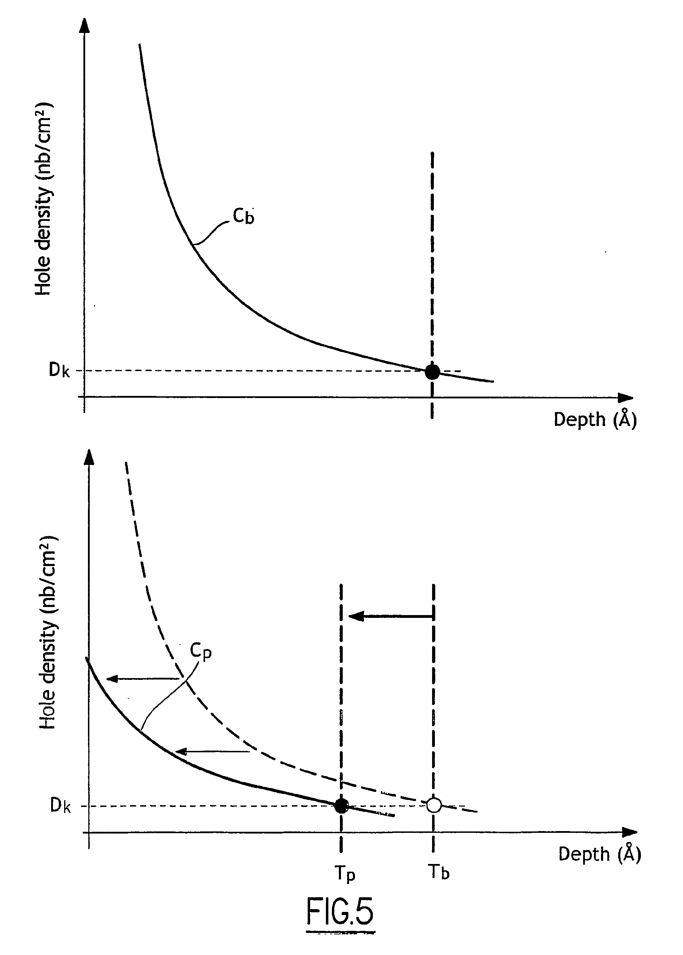

Figure 5 represents the hole density within a SOI layer before (top graph) and after (lower graph) a POL operation. Before the POL operation, the SOI layer of thickness Tb presents more or less deep shallow holes, in a density, illustrated by curve Cb, which depends upon the depth of these holes. The SOI layer also presents killing holes in a density Dk.

As mentioned here above, the POL operation has no effect on killing holes. The killing holes density thus remains unchanged equal to Dk.

However, the POL operation helps to cure the shallow holes, by decreasing their depth and even by stopping them. As a result of the POL operation, the SOI layer presents shallow holes in a strongly decreased density, as illustrated by curve Cp (which is identical to curve Cb but shifted along the depth axis due to the POL thickness consumption).

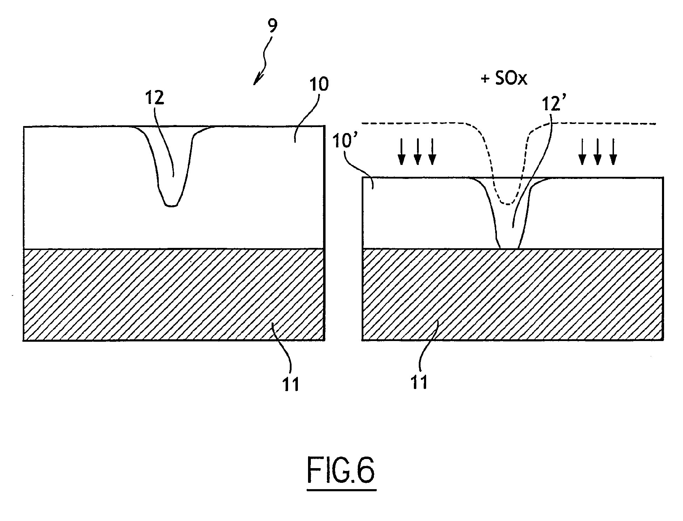

Figure 6 illustrates the effect of a SOx operation on a SOI structure 9 composed of a silicon layer 10 on top of a buried oxide layer 11. The silicon layer 10 presents prior to the SOx operation a shallow hole 12. As it is apparent on this figure, the SOx operation reproduces the shape of the hole and does not modify its depth.

As it is illustrated, if the depth of the initially present shallow hole 12 is important, it is possible that this hole extends, after a SOx operation, down to the buried oxide layer (killing hole 12').

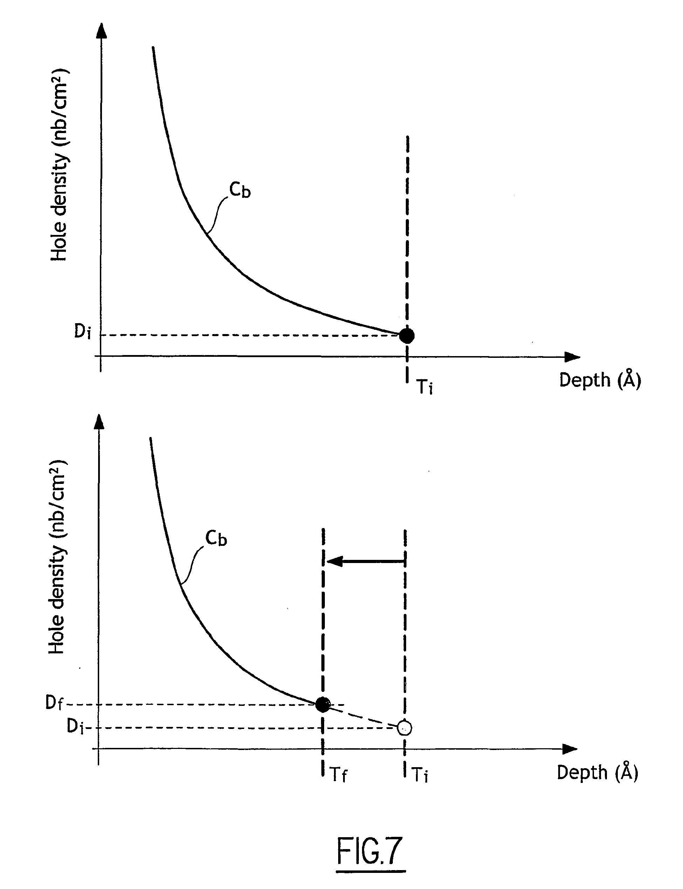

Figure 7 represents the holes density within a SOI layer before (top graph) and after (lower graph) a SOx operation. Before the SOx operation, the SOI layer of thickness Ti presents more or less deep shallow holes in a density, illustrated by curve Cb, which depends upon the depth of these holes. The SOI layer also presents killing holes in a density Di.

As mentioned here above, the SOx operation reproduces the shape of the holes and does not modify their depth. The shallow holes density is thus unchanged, and depends upon their depth as illustrated by the unchanged curve Cb.

However the thickness of the SOI layer is decreased by the SOx operation. As the new thickness Tf is lower than the initial thickness Ti, the density of killing holes thus increased from Di to Df.

As it is apparent from this figure 7, a SOx operation does not help to cure shallow holes, and result in an increase of the killing holes density (this increase relating directly to the consumed thickness Ti-Tf).

As for the SOx operation, a chemical etching operation reproduces the shape of the hole and does not modify its depth. As for the SOx operation, this even results in an initially important shallow hole extending subsequently down to the buried oxide layer, and being thus "converted" to a killing hole (or otherwise stated, it results in an increase of the killing holes density).

As it has been stated hereabove, a killing hole present prior to an operation of the first family (such as a RTA or POL operation), will not be cured by said operation.

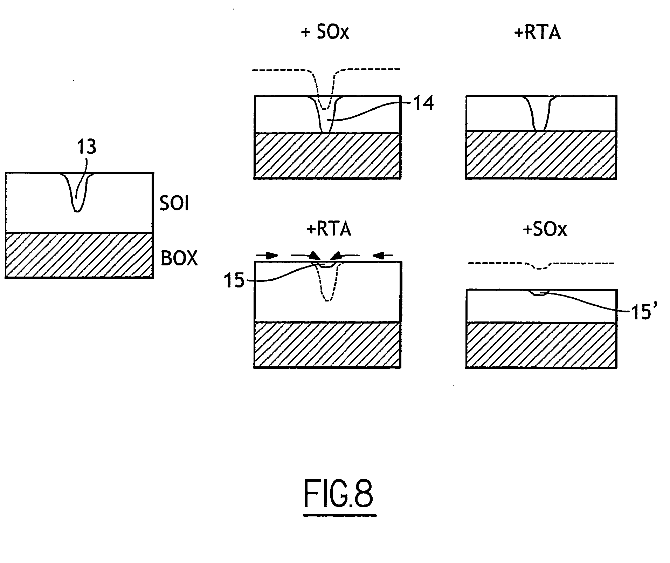

Hence, as it is apparent on figure 8, sequences RTA/SOx and SOx/RTA have a very different effect.

In the SOx/RTA sequence case, it is possible that the SOx operation transforms an initially (after transfer) shallow hole 13 into a killing hole 14. This killing hole 14 will not be cured by the following RTA operation.

On the other hand, in the RTA/SOx sequence case the same initially shallow hole 13 will be cured. Indeed the RTA operation will decrease its depth (see hole 15) while the SOx will thin the silicon layer. The resulting structure thus presents a quasi integrally restopped hole 15'.

Of course, if killing holes are present after transfer within the thin layer, these holes will not be cured and will remain, as killer defects, in the final product.

Based on the above observations, the use according to the second aspect of invention proposes to perform the steps of:
- selecting a thickness which is to be reached for the thin layer of the final structure,
- selecting a maximal density of killing holes to be observed within the thin layer of the final structure, and
- selecting a finishing sequence comprising at least one operation to be performed on the intermediate structure obtained after detachment.

A particular finishing sequence is generally used on the structure following the detachment step so as to improve the quality of the thin transferred layer (for instance by gumming out the roughnesses, insuring a correct thickness uniformity) and make it suitable for a use in the fields of application.

This finishing sequence is notably adapted for thinning the part of the donor substrate transferred onto the support substrate (thin transferred layer) so that the thickness of the thin layer of the final structure reaches said selected thickness.

Said finishing sequence may comprise at least one of the above mentioned operations (TA, POL, SOx, chemical etching) and may consist in any combination of these operations, such as the following sequences which are given as non restrictive examples:
- RTA-SOx;
- repetition of several RTA-SOx sequences (such as RTA-SOx-RTA-SOx);
- SOx-POL-SOx (and any repetition of this sequence);
- SOx-RTA-POL-SOx (and any repetition of this sequence);
- SOx-RTA (and any repetition of this sequence).

As mentioned above, a RTA operation (and more generally any smoothing annealing operation) helps stopping shallow holes. It is thus advantageous to make use of a sequence comprising such a RTA operation.

Moreover, under particular conditions, a RTA operation helps encapsulating the oxide layer under a Si layer, which may be favourable before performing a chemical etching or a sacrificial oxidation (see for instance WO 2004/079801)

However the position (defined in term of remaining thickness) of such an operation within a particular sequence may be important (see for instance US 2004/0151483).

Furthermore, a RTA operation is not effective for carrying out a removal of material and thinning the thin layer.

On the contrary, a SOx operation is effective for thinning the thin layer, in particular for removing the zone which is damaged after detachment or for obtaining the selected thickness of the thin layer of the final structure.

The thickness which can be removed by a SOx operation is typically comprised between 100 and 1000 angstroms

However a SOx operation must be carefully performed as it may increases the killing holes density.

It may hence be judicious to perform a RTA operation between two SOX operations.

A POL operation also helps thinning the thin layer by material removal but such an operation results in a degradation of the thickness uniformity and even in the thin layer being damaged. A POL has thus to be as much as possible limited, and to be performed after a thinning step (such as a SOx) which less damages the thin layer, or even after a RTA.

Typically a POL operation is combined with a RTA so as to limit the removal of material between 200 and 500 angstroms (which helps to limit the thickness uniformity degradation).

The method according to the first aspect of the invention proposes to perform the step of determining a minimum thickness of the part of the donor substrate which has to be transferred onto the support substrate for said part to present, after each operation of the finishing sequence, a density of killing holes less than said maximal density, and to reach said selected thickness once achieved the finishing sequence.

Hence the invention proposes to limit the density of killing holes within the thin layer of the final structure by selecting an adequate thickness to be transferred onto the support substrate and taking into account:
- the selected thickness which is to be reached for the thin layer of the final structure,
- the selected finishing sequence of operation(s) (and thus taking into account the effect upon holes density of each operation of this finishing sequence).

The above discussed graphs (figures 3, 5 and 7) show the effect upon holes density of each operation (respectively RTA, POL and SOx). These graphs may hence be combined to evaluate the effect upon holes density of a complete finishing sequence (which may have several operations performed in a particular order, and which is adapted for thinning the thin layer to the selected thickness).

The appropriate thickness to be transferred can thus be derived from this combination of graphs so that after each operation, the killing holes density is less than the selected maximal killing holes density. Starting from the selected final thickness and maximal density of killing holes, it is hence possible to determine, (taking the operation(s) of the finishing sequence in their reverse order and starting from the last one) which minimum thickness the thin layer must present before a particular operation, and thus finally which thickness has to be transferred.

Taking the upper diagram of figure 8 as an illustrative example, the selected finishing sequence comprises a SOx operation followed by a RTA operation. Graphs of figures 7 and 3 are thus to be combined.

The minimum thickness Ti to be transferred must take into account the fact that the thickness of the thin layer is decreased by the SOx operation (decreasing from Ti after transfer to Tf after the SOx operation), which results in an increase of the killing holes density.

Let's consider than the selected maximal density is set to 0,3 killing holes per cm². The minimum thickness Ti to be transferred must then be chosen so that the thickness Tf after the SOx operation and thus before the RTA operation (which has no impact upon killing holes density but helps lowering the shallow holes density) is greater than the thickness for which a killing holes density of 0,3/cm² is noticed (that is greater than 1000 angstroms).

Turning now to the lower graph of figure 8, the selected finishing sequence now comprises a RTA operation followed by a SOx operation. Graphs of figures 3 and 7 are thus to be combined. In this case, the first operation does not reduce the thickness of the thin layer but modifies the holes density such that the subsequent SOx operation is not susceptible to create (a lot of) new killing holes (SOx operation as illustrated on figure 7 but starting from a reduced holes density profile after the RTA operation as illustrated by curve Ca on the lower graph of figure 3).

Hence, it is understood that for a selected final thickness and a selected maximal density of killing holes, the minimum thickness to be transferred in the case of a RTA-SOx finishing sequence is different (in the present case lower) than the minimum thickness to be transferred in the case of a SOx-RTA finishing sequence.

Of course, the embrittlement zone is created in the thickness of the donor substrate at a depth substantially equal to or greater than said determined minimum thickness to be transferred.

According to a possible embodiment, the embrittlement zone is created by implantation of species under a face of the donor substrate from which the thin layer must be made.

Such an implantation can be performed by implanting a single species (such as hydrogen) or by implanting at least two different species (such as the co-implantation of helium and hydrogen).

According to a preferred embodiment of the second aspect of the invention, implantation conditions are selected so that the implantation energy is comprised between 15 keV and 120 keV, and more preferably between 15keV and 80 keV.

According to a preferred embodiment, the finishing sequence comprises at least one operation from said first family of operations, that is an operation which allows reducing the depth of the shallow holes and helps modifying the holes density within the thin layer (see effect of a RTA and of a POL operation on figures 3 and 5).

Said shallow holes depth reducing operation is for instance a TA operation, or a POL operation.

According to an advantageous embodiment of the second aspect of the invention, the finishing sequence comprises a plurality of operations from said first family of operations, that is a plurality of operations that each allows reducing the depth of shallow holes. This advantageous embodiment brings an additional profit as it decreases the depth of the residual shallow holes, and may even help to remove these shallow holes completely.

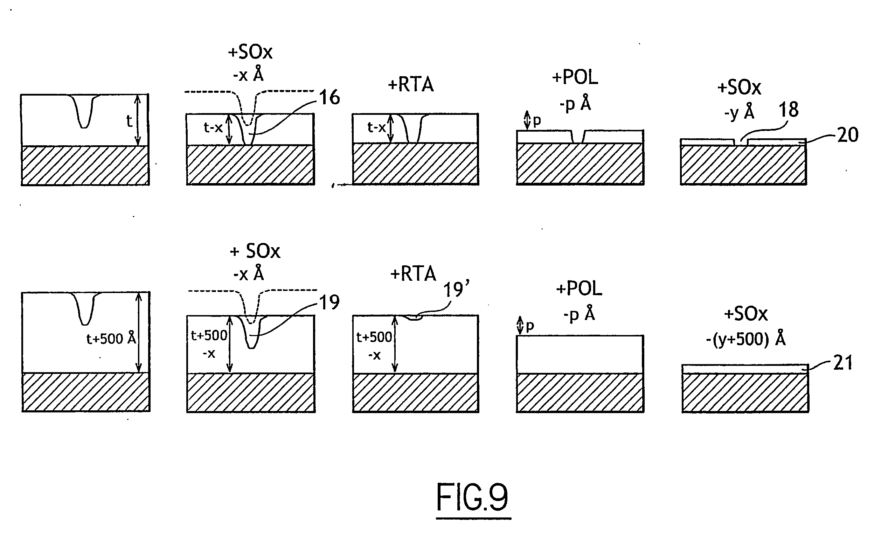

Figure 9 gives an example of the amelioration brought by a possible embodiment of the method according to the invention wherein the finishing sequence is a SOx/RTA/POL/SOx sequence of operations. Graphs of figures 7, 3, 5 and 7 are thus to be combined to determine, taking into account the selected thickness to be reached and the selected maximal density of killing holes, the minimum thickness which is to be transferred for the thin transferred layer to present, after each of these operations, a density of killing holes less than said selected density.

In the top diagram, the implantation step is carried out classically so that a layer of thickness t is transferred onto the donor substrate.

In the lower diagram, the implantation step is carried accordingly to the invention so that a layer of thickness t+500 angstroms is transferred onto the donor substrate.

In the classical case, the first SOx operation does not cure shallow holes and even leads to the formation of killing holes (such as hole 16) extending down to the buried oxide layer.

These killing holes can not be cured by the following RTA operation, nor by the following POL operation. The final SOx operation will lead to a SOI structure having a killing hole 18, and being thus not acceptable in its fields of application.

On the contrary, in the case of the use of the method according to a possible embodiment of the first aspect of invention, the transferred layer is thick enough for killing holes not to be formed (in a too important density exceeding the selected maximal density) by the first SOx operation.

Thus, in this case the subsequent RTA operation (that is an operation allowing to reduce the depth of shallow holes, such as hole 19) will help to cure the present shallow holes, notably by decreasing their depth (see hole 19'). This RTA operation has no impact upon the killing holes density, so that after this operation, the killing holes density still does not exceed the selected maximal density.

The POL operation will remove those shallow holes which are included within the thickness of the thin layer which is removed by this operation (in this case, those holes that are less deep than p angstroms, such as hole 19'). The POL operation will decrease the depth of the shallow holes that were, prior to this operation, deeper than p angstroms. As for the RTA operation, the POL operation does not impact the killing holes density.

Finally, at the end of the last operation (second SOx operation), a thin layer is obtained which presents the desired thickness, and a minimized density of holes, and in particular few shallow holes and a killing holes density less than said selected maximal density.

It has to be noted that this second SOx operation carries out a sacrificial oxidation adapted for obtaining a final thin layer 21 whose thickness is similar to that of the thin layer 20 classically obtained.

Hence this second SOx operation carries out a more important sacrificial oxidation, adapted to compensate for the thickness increase (+500 angstroms in the present case) of the transferred layer.

Moreover, the preceding example shows that a profit is reached, in term of density of killing holes, because the RTA operation (or more generally speaking an operation allowing to reduce the depth of the shallow holes) is performed on a thin layer which does not present killing holes (or at least which presents killing holes in a density lower than a maximal density).

Furthermore, killing holes density before said operation is controlled thanks to an implantation step adequately performed, notably by increasing the thickness of the layer being transferred onto the support substrate.

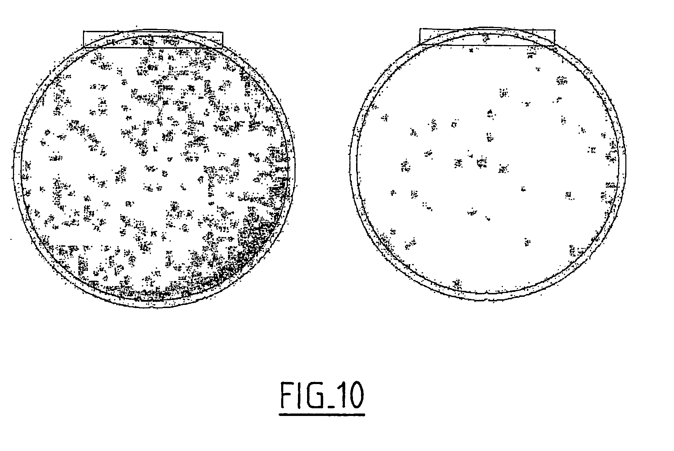

Figure 10 shows that an increase of 450 angstroms of the transferred layer, when combined with a finishing RTA/SOx/RTA/SOx sequence of operations, allows to decrease the density of killing holes by a factor 5 in the final thin layer (thickness 200 angstroms). Indeed the left hand side diagram drawn for a classically obtained SOI structure reveals a killing holes density of 0,5 holes/cm², while the right hand side diagram drawn for a SOI structure obtained as mentioned hereabove, reveals a killing holes density of 0,1 holes/cm² only.

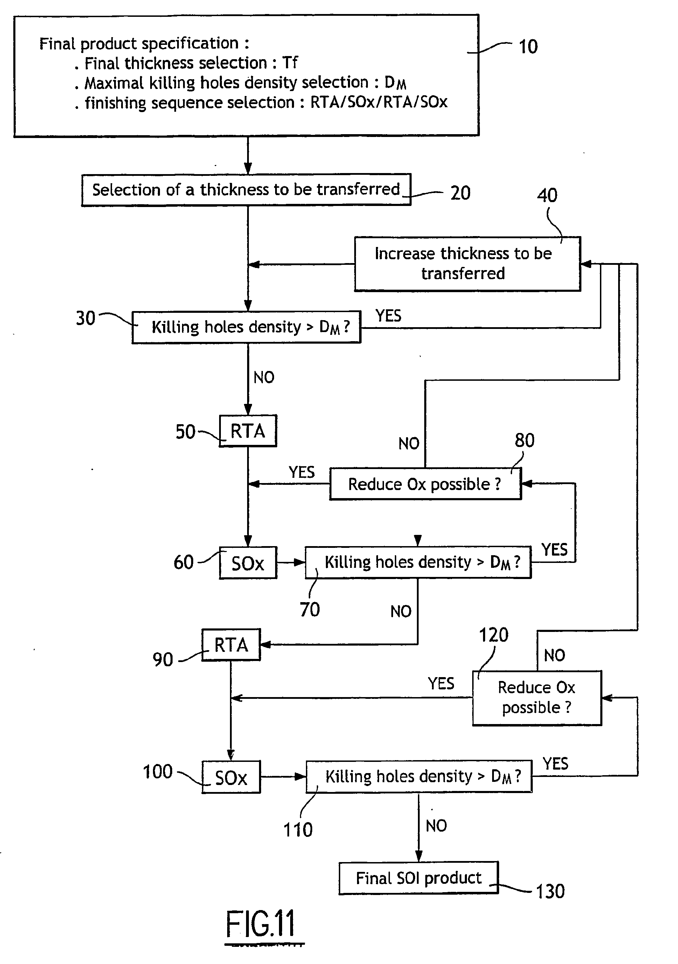

Figure 11 is a flow chart illustrating the use of a method according to a possible embodiment of the first aspect of the invention for the manufacturing of a SOI device.

At block 10, the specifications of the final SOI product are detailed, in particular by selecting:
- the thickness Tf of the thin layer of the final structure,
- the finishing sequence of operation(s) of the intermediate structure obtained after transfer (in this case a RTA/SOx/RTA/SOX sequence),
- and the maximal density of killing holes D_{M} within the thin layer of the final structure.

At block 20, a thickness to be transferred is selected.

At block 30, it is checked whether the density of killing holes within the part of the donor substrate which has been transferred onto the support substrate is higher than the selected maximal density D_{M} or not.

If yes, the thickness to be transferred is increased (block 40) and block 30 is thereafter repeated.

If no, the first operation of the finishing sequence is performed. In this case, at block 50, a RTA operation is performed. As already stated hereabove, such a RTA operation has no effect on killing holes, but helps reducing the depth of the shallow holes.

At block 60, the second operation of the finishing sequence, a SOx operation, is performed. As stated above, such a SOx operation is effective for thinning the transferred thin layer, but increases the killing holes density according to the thickness consumption.

At block 70, following the SOX operation, and similarly to block 30, it is checked whether the density of killing holes within the part of the donor substrate which has been transferred onto the support substrate is higher than the selected maximal density D_{M} or not.

If yes, at block 80, it is checked whether it is possible to decrease the thickness consumption of the SOx operation (performed at block 60). This is done by taking into account the selected particular finishing sequence, and the selected final thickness Tf.

If the thickness consumption can be decreased, the SOx operation is performed (block 60) according to this newly set operative conditions.

If the thickness consumption cannot be decreased, then block 40 is performed (that is increase of the transferred thickness).

Coming back to block 70, if the density of killing holes after the SOx operation is lower than the maximal density D_{M}, the next operation of the finishing sequence (here a RTA operation which does not consume thickness and does not modify the killing holes density) is performed at block 90.

A SOx operation is thereafter performed at block 100. At blocks 110 and 120 operations are performed which are similar to those performed respectively at blocks 70 and 80. Following the SOx operation, and provided that (block 110) the killing holes density is lower than the maximal density D_{M}, the final SOI product conform to the specifications (defined at block 10) is obtained at block 130.

Of course, it will be understood that the flowchart of figure 11 is purely illustrative and that the present invention is by no means limited to the embodiments described and represented, but the man skilled in the art will be able to bring many alternatives or modifications there within the scope of the appended claims.

## Claims

1. Method for determining the thickness of a part of a donor substrate which is to be transferred onto a support substrate (3a, 3b, 7, 11),, the method being **characterized in that,** considering a finishing sequence of operation(s) to which the transferred part is to be submitted so as to reach a final thickness (Tf), it comprises the steps of:
(1) selecting a thickness to be transferred;
(2) for an operation of the finishing sequence, checking the density of killing holes within the transferred part after said operation; and
- if the checked density is higher than a maximal density (D_{M}), increasing the thickness to be transferred and repeating step (2) while considering the increased thickness as the thickness to be transferred;
- if the checked density is lower than the maximal density (D_{M}), repeating step (2) for the next operation in the finishing sequence, until the finishing sequence is achieved and the transferred part reaches said final thickness (Tf).

2. Use of the method of claim 1 for producing a final structure (1a, 1b, 5, 9) comprising a thin layer of semiconductor material (2a, 2b, 6, 10') transferred from a donor substrate onto a support substrate (3a, 3b, 7, 11).

3. Use according to claim 2 comprising the steps of:
• creating an embrittlement zone in the thickness of a donor substrate,
• placing the donor substrate into close contact with the support substrate,
• detaching the donor substrate at the level of the embrittlement zone to transfer a part of the donor substrate onto the support substrate, thus forming an intermediate structure,
• applying a finishing sequence comprising at least one operation on the intermediate structure obtained after detachment;
• selecting a maximal density of killing holes to be observed within the thin layer of the final structures.

4. Use according to the claim 3, wherein the creation of an embrittlement zone in the thickness of the donor substrate is performed at a depth equal to or greater than said determined minimum thickness to be transferred.

5. Use according to claim 4, wherein the embrittlement zone is created by implantation of species under a face of the donor substrate from which the thin layer must be made, according to implantation conditions adapted for creating the embrittlement zone at said determined thickness.

6. Use according to any one of the claims 3 to 5, wherein the thickness determination is performed by taking into account the selected maximal killing holes density, the selected final thickness, and the effect of each operation of the finishing sequence upon the holes density.

7. Use according to any one of claims 5 or 6, further comprising the step of selecting implantation conditions by selecting an implantation energy comprised between 15 keV and 120 keV.

8. Use according to claim 7, wherein the implantation energy is comprised between 15 keV and 80 keV.

9. Use according to any one of claims 3 to 8, wherein the finishing sequence comprises at least one shallow holes depth reducing operations.

10. Use according to claim 9, wherein the finishing sequence comprises a plurality of shallow holes depth reducing operations.

11. Use according to any one of claims 9 or 10, wherein the finishing step comprises at least one treatment annealing (TA) operation, as a shallow holes depth reducing operation.

12. Use according to any one of claims 9 or 10, wherein the finishing step comprises at least one polishing (POL) operation, as a shallow holes depth reducing operation.

13. Use according to any one of claims 3 to 9, wherein the finishing sequence comprises at least one succession of the following operations: rapid treatment annealing (RTA) - sacrificial oxidation (SOx).

14. Use according to any one of claims 3 to 9, wherein the finishing sequence comprises at least one succession of the following operations : sacrificial oxidation (SOx) - rapid treatment annealing (RTA).

15. Use according to any one of claims 3 to 9, wherein the finishing sequence comprises at least one succession of the following operations: sacrificial oxidation (SOx) - polishing (POL) - SOx.

16. Use according to any one of claims 3 to 9, wherein the finishing sequence comprises at least one succession of the following operations: sacrificial oxidation (SOx) - rapid treatment annealing (RTA) - polishing (POL) - SOx.

17. Use according to any one of claims 3 to 16, wherein a layer of oxide is intercalated between the thin layer and the support substrate, the structure thus produced being a SeOI (Semiconductor On Insulator) structure.

18. Use according to claim 17, wherein the thin layer is formed from silicon, the structure thus produced being a SOI (Silicon On Insulator) structure.

## Patentansprüche

1. Verfahren zur Bestimmung der Dicke eines Teils eines Donatorsubstrates, der auf ein Trägersubstrat (3a, 3b, 7, 11) zu übertragen ist, wobei das Verfahren **dadurch gekennzeichnet ist, dass** es unter Berücksichtigung einer Endfertigungsreihenfolge eines Prozesses/von Prozessen, dem/denen der übertragene Teil derart zu unterwerfen ist, dass er eine Enddicke (Tf) erreicht, die Schritte umfasst:
(1) Auswählen einer zu übertragenden Dicke;
(2) für einen Prozess der Endfertigungsreihenfolge, Überprüfen der Dichte der Zerstörungslöcher (Killing holes) in dem übertragenen Teil nach dem Prozess; und
- wenn die überprüfte Dichte größer als eine maximale Dichte (D_{M}) ist, Vergrößern der zu übertragenden Dicke und Wiederholen des Schrittes (2), wobei die vergrößerte Dicke als die zu übertragende Dicke erachtet wird;
- wenn die überprüfte Dichte geringer ist als die maximale Dichte (D_{M}), Wiederholen von Schritt (2) für den nächsten Prozess in der Endfertigungsreihenfolge, bis die Endfertigungsreihenfolge vollendet ist und der übertragene Teil die Enddicke (Tf) erreicht.

2. Verwendung des Verfahrens gemäß Anspruch 1 zur Herstellung einer Endstruktur (1a, 1b, 5, 9) umfassend eine dünne Schicht aus einem von einem Donatorsubstrat auf ein Trägersubstrat (3a, 3b, 7, 11) übertragenen Halbleitermaterial (2a, 2b, 6, 10').

3. Verwendung gemäß Anspruch 2, weiterhin umfassend die Schritte:
- Erzeugen einer Versprödungszone in der Dicke eines Donatorsbustrates,
- Bringen des Donatorsubstrates und des Trägersubstrats in enge Berührung miteinander,
- Lösen des Donatorsubstrates an dem Niveau der Versprödungszone zur Übertragung eines Teils des Donatorsubstrates auf das Trägersubstrat, wodurch eine Zwischenstruktur gebildet wird,
- Anwenden einer wenigstens einen einzigen Prozess umfassenden Endfertigungsreihenfolge auf die Zwischenstruktur, die nach dem Lösen gewonnen wurde;
- Auswählen einer maximalen Dichte an zu beobachtenden Zerstörungslöchern (Killing holes) in der dünnen Schicht der Endstruktur.

4. Verwendung gemäß Anspruch 3, wobei das Erzeugen der Versprödungszone in der Dicke des Donatorsubstrates in einer Tiefe durchgeführt wird, die gleich oder größer als die bestimmte zu übertragende minimale Dicke ist.

5. Verwendung gemäß Anspruch 4, wobei die Versprödungszone durch Implantation von Teilchenarten unter eine Oberfläche des Donatorsubstrates, aus dem die dünne Schicht hergestellt sein muss, gemäß Implantationsbedingungen, die für die Erzeugung der Versprödungszone in der bestimmten Dicke geeignet sind, erzeugt wird.

6. Verwendung gemäß einem der Ansprüche 3 bis 5, wobei die Dickenbestimmung durchgeführt wird, indem die ausgewählte maximale Dichte der Zerstörungslöcher (Killing holes), die ausgewählte Enddicke und die Auswirkung jedes Prozesses der Endfertigungsreihenfolge auf die Löcherdichte berücksichtigt werden.

7. Verwendung gemäß einem der Ansprüche 5 oder 6, weiterhin umfassend den Schritt der Auswahl der Implantationsbedingungen, indem eine Implantationsenergie, die zwischen 15 keV und 120 keV liegt, ausgewählt wird.

8. Verwendung gemäß Anspruch 7, wobei die Implantationsenergie zwischen 15 keV und 80 keV liegt.

9. Verwendung gemäß einem der Ansprüche 3 bis 8, wobei die Endfertigungsreihenfolge wenigstens einen Prozess zur Reduzierung der Tiefe der oberflächlichen Löcher (shallow holes) umfasst.

10. Verwendung gemäß Anspruch 9, wobei die Endfertigungsreihenfolge eine Vielzahl an Prozessen zur Reduzierung der Tiefe der oberflächlichen Löcher (shallow holes) umfasst.

11. Verwendung gemäß einem der Ansprüche 9 oder 10, wobei der Endfertigungsschritt wenigstens einen Ausheilungsprozess (TA) als Prozess zur Reduzierung der Tiefe der oberflächlichen Löcher (shallow holes) umfasst.

12. Verwendung gemäß einem der Ansprüche 9 oder 10, wobei der Endfertigungsschritt wenigstens einen Polierprozess (POL) als einen Prozess zur Reduzierung der Tiefe der oberflächlichen Löcher (shallow holes) aufweist.

13. Verwendung gemäß einem der Ansprüche 3 bis 9, wobei die Endfertigungsreihenfolge wenigstens eine Abfolge der folgenden Prozesse umfasst: schnelles Ausheilen (RTA) - Opferoxidation (SOx).

14. Verwendung gemäß einem der Ansprüche 3 bis 9, wobei die Endfertigungsreihenfolge wenigstens eine Abfolge der folgenden Prozesse umfasst: Opferoxidation (SOx) - schnelles Ausheilen (RTA).

15. Verwendung gemäß einem der Ansprüche 3 bis 9, wobei die Endfertigungsreihenfolge wenigstens eine Abfolge der folgenden Prozesse umfasst: Opferoxidation (SOx) - Polieren (POL) - SOx.

16. Verwendung gemäß einem der Ansprüche 3 bis 9, wobei die Endfertigungsreihenfolge wenigstens eine Abfolge der folgenden Prozesse umfasst: Opferoxidation (SOx) - schnelles Ausheilen (RTA) - Polieren (POL) - SOx.

17. Verwendung gemäß einem der Ansprüche 3 bis 16, wobei eine Oxidschicht zwischen die dünne Schicht und das Trägersubstrat eingefügt ist, wobei die so hergestellte Struktur eine SeOI (Semiconductor on Insulator) Struktur ist.

18. Verwendung gemäß Anspruch 17, wobei die dünne Schicht aus Silizium gebildet ist, wobei die so hergestellte Struktur eine SOI (Silicon on Insulator) Struktur ist.

## Revendications

1. Procédé pour déterminer l'épaisseur d'une partie d'un substrat donneur qui doit être transférée sur un substrat de support (3a, 3b, 7, 11), le procédé étant **caractérisé en ce que**, considérant une séquence d'opération(s) de finition à laquelle la partie transférée doit être soumise de façon à atteindre une épaisseur finale (Tf), il comprend les étapes consistant à :
(1) sélectionner une épaisseur devant être transférée ;
(2) pour une opération de la séquence de finition, vérifier la densité des trous traversants à l'intérieur de la partie transférée après ladite opération ; et
- si la densité vérifiée est supérieure à une densité maximale (D_{M}), augmenter l'épaisseur devant être transférée et répéter l'étape (2) tout en prenant en compte l'épaisseur accrue en tant qu'épaisseur devant être transférée ;
- si la densité vérifiée est inférieure à la densité maximale (D_{M}), répéter l'étape (2) pour l'opération suivante dans la séquence de finition, jusqu'à ce que la séquence de finition soit achevée et que la partie transférée atteigne ladite épaisseur finale (Tf).

2. Utilisation du procédé de la revendication 1 pour produire une structure finale (1a, 1b, 5, 9) comprenant une couche mince de matériau semi-conducteur (2a, 2b, 6, 10') transférée depuis un substrat donneur sur un substrat de support (3a, 3b, 7, 11).

3. Utilisation selon la revendication 2, comprenant les étapes consistant à :
• créer une zone de fragilisation dans l'épaisseur d'un substrat donneur,
• placer le substrat donneur en contact étroit avec le substrat de support,
• détacher le substrat donneur au niveau de la zone de fragilisation pour transférer une partie du substrat donneur sur le substrat de support, en formant ainsi une structure intermédiaire,
• appliquer une séquence de finition comprenant au moins une opération sur la structure intermédiaire obtenue après détachement ;
• sélectionner une densité maximale de trous traversants devant être observés à l'intérieur de la couche mince de la structure finale.

4. Utilisation selon la revendication 3, dans laquelle la création d'une zone de fragilisation dans l'épaisseur du substrat donneur est effectuée à une profondeur égale ou supérieure à ladite épaisseur minimale déterminée devant être transférée.

5. Utilisation selon la revendication 4, dans laquelle la zone de fragilisation est créée par implantation d'espèces sous une face du substrat donneur à partir de laquelle la couche mince doit être produite, conformément à des conditions d'implantation adaptées pour créer la zone de fragilisation à ladite épaisseur prédéterminée.

6. Utilisation selon l'une quelconque des revendications 3 à 5, dans laquelle la détermination d'épaisseur est effectuée par prise en compte de la densité maximale sélectionnée de trous traversants, de l'épaisseur finale sélectionnée, et de l'effet de chaque opération de la séquence de finition sur la densité des trous.

7. Utilisation selon l'une quelconque des revendications 5 ou 6, comprenant en outre l'étape consistant à sélectionner des conditions d'implantation par sélection d'une énergie d'implantation comprise entre 15 keV et 120 keV.

8. Utilisation selon la revendication 7, dans laquelle l'énergie d'implantation est comprise entre 15 keV et 80 keV.

9. Utilisation selon l'une quelconque des revendications 3 à 8, dans laquelle la séquence de finition comprend au moins une opération de réduction de la profondeur de trous peu profonds.

10. Utilisation selon la revendication 9, dans laquelle la séquence de finition comprend une pluralité d'opération de réduction de la profondeur de trous peu profonds.

11. Utilisation selon l'une quelconque des revendications 9 ou 10, dans laquelle l'étape de finition comprend au moins une opération de traitement de recuit (TA) en tant qu'opération de réduction de la profondeur des trous peu profonds.

12. Utilisation selon l'une quelconque des revendications 9 ou 10, dans laquelle l'étape de finition comprend au moins une opération de polissage - (POL) en tant qu'opération de réduction de la profondeur des trous peu profonds.

13. Utilisation selon l'une quelconque des revendications 3 à 9, dans laquelle la séquence de finition comprend au moins une succession des opérations suivantes : traitement de recuit rapide (RTA) - oxydation sacrificielle (SOx).

14. Utilisation selon l'une quelconque des revendications 3 à 9, dans laquelle la séquence de finition comprend au moins une succession des opérations suivantes : oxydation sacrificielle (SOx) - traitement de recuit rapide (RTA).

15. Utilisation selon l'une quelconque des revendications 3 à 9, dans laquelle la séquence de finition comprend au moins une succession des opérations suivantes : oxydation sacrificielle (SOx) - polissage (POL) - SOx.

16. Utilisation selon l'une quelconque des revendications 3 à 9, dans laquelle la séquence de finition comprend au moins une succession des opérations suivantes : oxydation sacrificielle (SOx) - traitement de recuit rapide (RTA) - polissage (POL) - SOx.

17. Utilisation selon l'une quelconque des revendications 3 à 16, dans laquelle une couche d'oxyde est intercalée entre la couche mince et le substrat de support, la structure ainsi produite étant une structure SeOI (semi-conducteur sur isolant).

18. Utilisation selon la revendication 17, dans laquelle la couche mince est formée à partir de silicium, la structure ainsi produite étant une structure SOI (silicium sur isolant).
